# EUROPÄISCHE PATENTANMELDUNG

(11) **EP 0 536 642 A1**
(43) Veröffentlichungstag der Anmeldung: **14.04.1993**
(21) Anmeldenummer: 92116824.1
(22) Anmeldetag: 01.10.1992
(51) Int. Cl.: G01R 31/28

(54) **Drehtisch zur Prüfung von elektromagnetischer Verträglichkeit**

(30) Priorität: 10.10.1991 DE 9112632 U
(71) Anmelder: SIEMENS AKTIENGESELLSCHAFT, D-80333 München (DE)
(72) Erfinder: Syassen, Edo, W-8522 Herzogenaurach (DE); Kohling, Anton, Dipl.-Ing., W-8555 Adelsdorf (DE); Balzer, Gerd, W-6729 Neuburg (DE)

(57) **Zusammenfassung**

Der Drehtisch dient zum Abstellen von technischen Objekten, welche zur Prüfung von deren elektromagnetischer Verträglichkeit allseitig mit elektromagnetischen Wellen bestrahlt werden. Er weist eine separate Tischplatte (DR) mit Kupplungsmitteln (KO) auf der Unterseite (U) annähernd im Schwerpunkt (Z) auf. In diese kann eine separate Zentrumswelle (W) vertikal eingefahren werden. Ein Antrieb (M1;RA) dient zur Drehung der Tischplatte in dem in die Kupplungsmittel eingefahrenen Zustand der Zentrumswelle. Auf der Unterseite (U) der Tischplatte sind Rollmittel (LK) vorhanden bzw. anbringbar, so daß diese komplett mit dem darauf befindlichen technischen Objekt im ausgefahrenen Zustand der Zentrumswelle auf dem Boden (B) frei verschiebbar ist. Dies hat den Vorteil, daß die Tischplatte ohne Änderung des Aufbaus des technischen Objektes aus der Absorberhalle ausgeschoben werden kann.

## Beschreibung

Die Erfindung betrifft einen Drehtisch zum Abstellen von technischen Objekten, welche zur Prüfung von deren elektromagnetischer Verträglichkeit allseitig von insbesondere hochfrequenten elektromagnetischen Wellen bestrahlt werden.

Der elektromagnetischen Verträglichkeit von technischen Objekten, d.h. deren Unempfindlichkeit gegenüber einfallenden elektromagnetischen Wellen, kommt eine ständig wachsende Bedeutung zu. So darf die Betriebssicherheit und Funktionalität von Gebrauchsgütern auch dann in keiner Weise eingeschränkt sein, wenn diese unter Umständen plötzlich insbesondere hochfrequenten und leitungsstarken elektromagnetisch Bestrahlungen ausgesetzt sind. Dies betrifft insbesondere technische Objekte, in denen unter Umständen eine Vielzahl von hochfrequenten elektrischen Signalen zirkulieren, welche zum Austausch und zu Übertragung von Daten dienen.

So müssen insbesondere solche technische Objekte im Rahmen eines sogenannten EMV-Tests auf deren elektromagnetische Verträglichkeit überprüft werden, welche elektrische und elektronische Komponenten enthalten. Als Beispiele hierfür seien genannt: Anlagen zur Datenverarbeitung, z.B. Computer und die dazugehörigen Peripheriegeräte; Anlagen zur Energieversorgung, z.B. Schaltgeräte, Schaltschränke, Transformatoren und dergleichen; Kraftfahrzeuge, welche z.B. elektronische Kraftstoffeinspritzanlagen und Systeme zum Motor-Management aufweisen; Flugzeugtriebwerke; wehrtechnische Anlagen und vieles mehr.

Die Prüfung derartige technische Objekte erfolgt in der Regel in speziell aufgebauten, sogenannten Absorberhallen. Diese sind nach außen elektromagnetisch abgeschirmt und verfügen über elektromagnetisch abdichtende Zugänge, wie z.B. Türen und Tore. Die Hallen sind im Inneren so ausgekleidet, daß möglichst keine Reflexionen von elektromagnetischen Wellen auftreten. Hierzu sind meist zumindest die Wände und Decken vollständig mit spitzen, pyramidenförmigen Absorberkörpern belegt.

Bei der Überprüfung der elektromagnetischen Verträglichkeit ist es wesentlich, daß das jeweilige technische Objekt gleichmäßig von allen Seiten elektromagnetischer Strahlung im jeweils interessierenden Frequenzbereich ausgesetzt wird. Hierzu dienen sogenannte Drehtische, welche eine gleichmässige Bestrahlung des zu überprüfenden technischen Objektes im Inneren der Absorberhalle von allen Seiten ermöglichen. Dabei sind freistehende, d.h. auf dem Hallenboden aufgestellte Drehtische, und in den Hallenboden unter Umständen vollständig eingelassene, d.h. kantenlose, Drehtische bekannt.

Es besteht nun ein Problem darin, daß das auf elektromagnetische Verträglichkeit zu überprüfende technische Objekt in einem vollständig betriebsfähigen Zustand auf dem jeweiligen Drehtisch installiert werden muß. Insbesondere bei elektrotechnischen Geräten wie z.B. Schaltschränken, nehmen derartige Aufbauten eine erhebliche Vorbereitungszeit in Anspruch. Während dieser Aufbauphase ist die Nutzung der Absorberhalle blockiert. Durch diese Wartezeiten können erhebliche Kosten entstehen, da für die zur Verfügungstellung einer Absorberhalle mietähnliche Gebühren in unter Umständen erheblicher Höhe aufzuwenden sind.

Der Erfindung liegt die Aufgabe zugrunde, einen Drehtisch in einer Absorberhalle zur Prüfung von technischen Objekten auf elektromagnetische Verträglichtkeit konstruktiv derart auszugestalten, daß ein schneller Austausch der jeweils zu prüfenden technischen Objekte möglich wird.

Die Aufgabe wird gelöst mit dem im Anspruch angegebenen Drehtisch. Vorteilhafte weitere Ausgestaltungen desselben sind in den Unteranprüchen angegeben.

Die Erfindung wird desweiteren an Hand von zwei in den nachfolgend kurz angeführten Figuren dargestellten Ausführungsbeispielen näher erläutet. Dabei zeigt
- FIG 1: beispielhaft einen Drehtisch mit einer auf dem Hallenboden aufliegenden Tischplatte und einer in einem Aufnahmeschacht versenkt angeordnet Zentrumswelle, und
- FIG 2: beispielhaft einen Drehtisch mit einer auf einem separaten Zwischenboden aufliegenden Tischplatte und einer auf dem darunter befindlichen Hallenboden aufgesetzten Zentrumswelle.

Der Drehtisch weist erfindungsgemäß eine separate Tischplatte auf, welche auf der Unterseite in der Rotationsachse Kupplungsmittel aufweist. In diese kann eine separate Zentrumswelle mit Hilfe von Hubmitteln vertikal ein- bzw. daraus ausgefahren werden. Zudem sind auf der Unterseite der Tischplatte erfindungsgemäß Rollmittel vorhanden bzw. bei Bedarf anbringbar, so daß die separate Tischplatte im ausgefahrenen Zustand der Zentrumswelle auf einem Boden frei verschiebbar ist. Schließlich weist der erfindungsgemäße Drehtisch einen Antrieb auf, mit dessen Hilfe die Tischplatte dann in Drehung versetzt werden kann, wenn die Zentrumswelle in die Kupplungsmittel eingefahren ist.

Eine derartige Anordnung hat den Vorteil, daß die wesentlichen Bauelemente des Drehtisches, d.h. die Tischplatte, die Zentrumswelle und der Antrieb, nicht starr miteinander verbunden sind, sondern bei Bedarf durch Absenken der separaten Zentrumswelle voneinander entkoppelt werden können. Die separate Tischplatte kann somit komplett mit dem jeweils darauf abgestellt technischen Objekt durch Verschiebung auf dem Boden aus der Absorberhalle herausgeschoben werden. Umbauten an dem auf elektromatische Verträchlichkeit zu prüfenden technischen Objekt bzw. der Ab- und Aufbau derartiger Objekte auf die bzw. von der Tischplatte muß nicht mehr im Inneren der Absorberhalle durchgeführt werden, sondern kann außerhalb in angrenzenden Laborräumen erfolgen. Gleichzeitig kann eine andere Tischplatte, auf deren Oberfläche vorher ein anderes Prüfobjekt aufgestellt und in Betrieb gesetzt wurde, in die Absorberhalle eingefahren und dort an die separate Zentrumswelle angekuppelt werden. Alle Aufbau-, Umrüst-, Montage- und Justierarbeiten an einem technischen Objekt können somit außerhalb der Absorberhalle durchgeführt werden, ohne daß hierdurch der Meßbetrieb der Absorberhalle unterbrochen werden muß und ohne daß ein der EMV-Prüfung zu unterwerfendes technisches Objekt unter Umständen mehrfach von der Tischplatte des Drehtisches entnommen und nach Durchführung von Umrüstarbeiten wieder aufgesetzt werden muß. Für die Gesamtdauer eines Prüfzyklusses wird somit einem technischen Objekt eine separate Tischplatte fest zugeordnet. Der meßtechnische Aufbau insbesondere zur Herstellung der Betriebsfähigkeit des technischen Objektes muß somit auf der zugeordnet separaten Tischplatte nur einmal installiert werden und kann trotz vorübergehender Unterbrechnungen bei der Prüfung aufrechterhalten bleiben. Die Erfindung hat somit den besonderen Vorteil, daß ein technisches Objekt komplett mit der als Unterlage dienenden, separaten Tischplatte bei Bedarf mehrfach aus der Absorberhalle herausgefahren und nach Durchführung irgendwelcher Arbeiten zur Fortsetzung der EMV-Prüfung problemlos wieder in die Absorberhalle eingefahren werden kann.

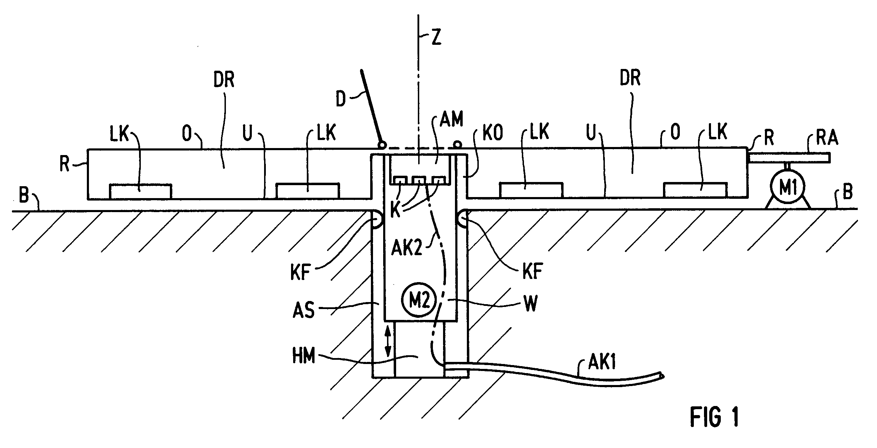

In FIG 1 ist eine mögliche Ausführungsform eines gemäß der Erfindung aufgebauten Drehtisches beispielhaft dargestellt. Die separate Tischplatte TR liegt dabei unmittelbar auf dem Boden B auf. Dieser stellt z.B. einen bevorzugt mit einem elektrisch leitenden Belag versehenen, begeh- und befahrbaren Boden in einer Absorberhalle dar. Auf der Oberseite O der Tischplatte DR können beliebige, in FIG 1 nicht dargestellte technische Objekte abgestellt werden. Die Tischplatte DR weist in der Rotationsachse Z auf der Unterseite U Kupplungsmittel KO auf. In diese kann erfindungsgemäß eine separate Zentrumswelle W vertikal eingefahren bzw. daraus wieder ausgefahren werden. Das Einfahren der Zentrumswelle W in die Kupplungsmittel KO auf der Unterseite der Tischplatte hat die Wirkung, daß die Tischplatte TR auf dem Boden B nicht mehr verschiebbar ist, sondern lediglich um die Achse Z rotieren kann.

Erfindungsgemäß sind auf der Unterseite U der Tischplatte DR zudem Rollmittel LK vorhanden bzw. anbringbar, so daß die separate Tischplatte DR im ausgefahrenen Zustand der Zentrumswelle auf dem Boden B frei verschiebbar ist. Als Rollmittel können beispielhaft Gummiräder vorhanden bzw. bei Bedarf leicht unter die Unterseite U der Tischplatte unterlegbar sein. Bei einer anderen, in FIG 1 bereits dargestellten Ausführungsform dienen als Rollmittel bevorzugt fest in die Unterseite U eingebauten Luftkissen LK. Bevorzugt sind derartige Luftkissen gleichmäßig auf der gesamten Unterseite U verteilt angeordnet und aus nichtleitendem Material gefertigt. Gemäß einer weiteren Ausführungsform sind die Rollmittel LK zudem derart ausgelegt, daß auch in dem in die Kupplungsmittel KO der Tischplatte DR eingefahrenen Zustand der Zentrumswelle W eine kipp- und reibungsfreie Drehung der Tischplatte auf dem Boden B möglich ist. Eine derartige Ausführung ist insbesondere in den Fällen von Vorteil, in denen die Tischplatte entweder große Abmessungen aufweist, und/oder gegebenenfalls einseitig mit schweren technischen Objekten belasten ist. Die Rollmittel ermöglichen dann sowohl eine leichte Drehbarkeit der Tischplatte bei Durchführung einer EMV-Prüfung, als auch eine leichte Verschiebbarkeit der Tischplatte bei Unterbrechungen der Prüfung.

Gemäß einer weiteren, in FIG 1 bereits dargestellten Ausführungsform ist die separate Zentrumswelle W gemeinsam mit den zu ihrem Antrieb dienenden Hubmitteln in einem in Boden B eingelassenen Aufnahmeschacht AS untergebracht. Hierdurch ist es möglich, die separate Tischplatte DR nahezu unmittelbar auf dem Boden B aufliegend anzuordnen. Bei Bedarf kann die Tischplatte durch weiteres Ausfahren der Zentrumswelle W unter Umständen auch angehoben werden, so daß eine allseitige Bestrahlung des auf der Oberfläche O abgestellten technischen Objektes in erhöhter Position möglich ist. Bei einer anderen, in den Figuren nicht dargestellten Ausführungsform ist es auch möglich, daß die separate Tischplatte DR derart in den Hallenboden B eingelassen ist, daß sich ein stufenloser, vollständig ebener Übergang zwischen der Tischplatteoberfläche O und der Bodenoberfläche B ergibt. In diesem Fall müßte die separate Tischplatte zum Austausch über die separate Zentrumswelle und die Hubmittel zunächst aus der Mulde im Boden B herausgehoben und dann mit geeigneten Mitteln in dieser Position gehalten werden, so daß anschließend die separate Zentrumswelle durch Absenken aus den Kupplungsmitteln ausgefahren werden kann.

Als Hubmittel HM für die vertikal bewegbare, separate Zentrumswelle können unterschiedliche Ausführungsformen zur Anwendung kommen. So ist es z.B. möglich, die Hub- und Absenkbewegung der Welle W mit Hilfe von hydraulisch betriebenen Druckluftzylindern zu bewerkstelligen. Bei anderen Ausführungsformen kann die Zentrumswelle W auch mit Hilfe einer elektrisch betriebenen Spindel mechanisch ein- und ausgefahren werden. Im Beispiel der FIG 1 ist symbolisch ein Elektromotor M2 als Antrieb für die Hubmittel dargestellt. Ein Doppelpfeil im Inneren des Aufnahmeschachtes AS symbolisiert den Hubbereich der separaten Zentrumswelle W.

Desweiteren sind am oberen Ende des Aufnahmeschachtes AS Abdichtmittel KF vorgesehen, welche auf der Oberfläche der ein-und ausfahrbaren Zentrumswelle W aufliegen und zumindest eine mechanische Abdichtung des Aufnahmeschachtes AS gegenüber dem Hallenboden B bewirken. In dem Fall, bei dem der Boden B mit einem elektrisch leitenden Belag versehen ist, können sowohl die Zentrumswelle W als auch die Kontaktmittel KF elektrisch leitend ausgeführt sein. Als Kontaktmittel eignen sich dann besonders gekrümmte Kontaktfederbänder. Hierdurch wird eine durchgehende elektrische Leitung des Hallenbodens B auch über den Aufnahmeschacht AS und die Zentrumswelle W hinweg ermöglicht.

Abhängig von der Art der jeweiligen Prüfung auf elektromagnetische Verträglichkeit kann die separate Tischplatte DR aus unterschiedlichen Materialen gefertigt sein. Bevorzugt ist sie aus einem elektrisch nicht leitenden Material gefertigt, z.B. Holz oder Kunststoff. Zudem können die Dicke der Tischplatte und die Höhe des Kopfes der Zentrumswelle in dem in die Kupplungsmittel KO auf der Unterseite U eingefahrenen Zustand derart aufeinander abgestimmt sein, daß die Oberseite O einen vorgebbaren Abstand von z.B. 10 cm vom Boden B einnimmt.

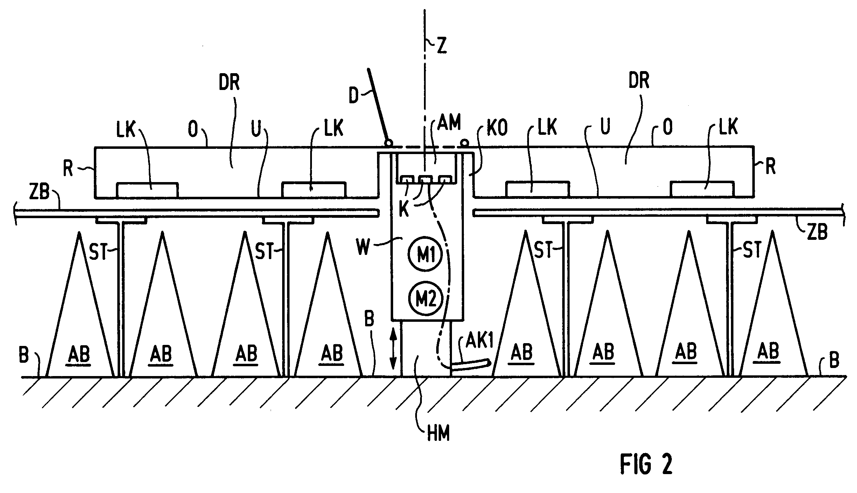

Desweiteren kann die separate Tischplatte DR unterschiedliche Formen aufweisen. Bevorzugt ist die Tischplatte gemäß der Darstellung in den Figuren 1, 2 kreisrund ausgeführt. In einem solchen Fall kann der zur Drehung der Tischplatte in dem in die Kupplungsmittel KO eingefahrenen Zustand der Zentrumswelle W dienende Antrieb M1 auf einfache Weise beispielhaft über ein Reibrad RA direkt auf den Außenrand R der Tischplatte DR eingreifen. Der Antrieb M1 kann dabei entweder neben der Tischplatte auf der Oberfläche des Bodens B montiert sein, oder gemäß einer anderen, nicht dargestellten Ausführungsform in einem weiteren Aufnahmeschacht eingelassen sein. Bei einer weiteren Ausführungsform kann der Antrieb zur Drehung der Tischplatte auch auf die Zentrumswelle W einwirken. Besonders vorteilhaft kann dieser dann in Form eines Direktantriebes bevorzugt in der Rotationsachse Z liegend direkt in die Zentrumswelle integriert sein. Greift dieser Antrieb auf die Zentrumswelle ein, so kann die Tischplatte DR eine beliebige Form aufweisen. Es ist dann auch eine quadratische, recht- bzw. vieleckige Form möglich. Bei direktem Antrieb der Tischplatte über die Zentrumswelle ist notwendig, daß die Kontaktmittel KO auf der Unterseite U der Tischplatte TR eine verdrehsichere Verbindung mit der Zentrumswelle W im eingefahrenen Zustand herstellen. Andernfalls ist es ausreichend, daß die Tischplatte DR im eingefahrenen Zustand der Zentrumswelle über Kupplungsmittel KO möglichst reibungsarm auf dem Kopf der Zentrumswelle drehbar gelagert ist.

Gemäß einer weiteren, in FIG 1 bereits dargestellten Ausführungsform sind im Kopfbereich der Zentrumswelle W, welche den Kupplungsmitteln KO auf der Unterseite U der Tischplatte DR zugewandt ist, Anschlußmittel AM angeordnet. Diese können insbesondere zur Ernergieversorgung und/oder zur Übergabe von Steuersignalen für das mindestens eine auf dem Drehtisch abgestellte technische Objekt genutzt werden. Bei dieser Ausführungsform sind auf der Oberseite O der Tischplatte DR annähernd in der Rotationsachse Z liegend desweiteren Mittel D vorhanden, welche von oben einen Zugang zu den Anschlußmitteln zumindest in dem in die Kupplungsmittel KO eingefahrenen Zustand der Zentrumswelle W ermöglichen.

Im Beispiel der FIG 1 sind diese Anschlußmittel in einem Anschlußschacht bzw. einer Anschlußmulde AM im Kopfbereich` der vertikal verschiebbaren Zentrumswellen Z untergebracht. Bei den Anschlußmitteln K handelt es sich insbesondere um Stecker und Kupplungen für Leitungen zur elektrischen, pneumatischen oder hydraulischen Versorgung. An diese Anschlußmittel kann ein nicht dargestelltes, auf der Oberfläche O abgestelltes technisches Objekt zur Herstellung von dessen Betriebsfähigkeit angeschlossen werden. Die Anschlußmulde AN ist bevorzugt über einen Deckel D auf der Oberseite O der Tischplatte leicht zugänglich. Zudem ist der Anschlußschacht AN annähernd in der Rotationsachse Z der Tischplatte DR liegend zentral gut zugänglich. Insbesondere dann, wenn mehrere Prüflinge auf der bevorzugt kreisrunden Tischplatte radial um die Rotationsachse Z auf der Oberfläche O abgestellt sind, können diese auf einfache Weise über die im Zentrum liegenden Anschlußmittel K im Anschlußschacht AN angeschlossen werden. Falls die Prüfung der technischen Objekte auf deren elektromagnische Verträglichkeit vorübergehend unterbrochen werden soll und die separate Tischplatte DR komplett mit den darauf abgestellten Objekten aus der Absorberhalle vorübergehend ausgefahren werden soll, so ist es lediglich notwendig, die zu dem Prüfling führenden Leitungen von den Anschlußmitteln K im Anschlußschacht AM zu trennen und die separate Zentrumswelle vertikal aus den Kupplungsmitteln auszufahren. Der gesamte übrige, unter Umständen sehr aufwendige Versuchsaufbau auf der Oberfläche der Tischplatte kann völlig unangetastet bleiben.

Im Beispiel der FIG 1 wird ein erstes Hauptanschlußkabelbündel K1 dem Drehtisch über die separate Zentrumswelle W im Füßbereich des Aufnahmeschachtes AS zugeführt. Hierüber kann die Eigenversorgung der Betriebsmittel des Drehtisches und die Fremdversorgung der Anschlußmittel K in der Anschlußmulde AM für die Prüflinge auf der Oberseite O mit Energie, und der Austausch von Steuer- und Regelsignalen hergestellt werden. So können z.B. die Luftkissen LK auf der Unterseite U des Drehtisches mit Druckluft und ein beispielhaft als Antrieb für die Hubmittel der separaten Zentrumswelle dienender Elektromotor M2 mit elektrischer Energie vorsorgt werden. Desweiteren können den Anschlußmitteln K über ein weiteres, strichpunktiert dargestelltes Anschlußkabel AK2 die von den jeweiligen Prüflingen auf der Oberseite O benötigten Versorgungsmedien zugeführt werden, z.B. elektrischen Strom bzw. Druckluft.

FIG 2 zeigt ein weiteres Beispiel eines gemäß der Erfindung aufgebauten Drehtisches. Die separate Tischplatte DR steht dabei mit der Unterseite U mit einem separat eingezogenen Zwischenboden ZB in Verbindung. Der Zwischenboden besteht bevorzugt aus nicht leitendem Material, z.B. Holz, und ist über Stützen ST auf dem eigentlichen Boden B der Absorberhalle aufgestellt. In dem Raum zwischen dem Hauptboden B und dem zusätzlichen Zwischenboden ZB sind spitze, pyramidenförmige Absorberkörper AB aufgestellt. Mit einer derartigen Anordnung ist es möglich, Reflexionen der zur Bestrahlung des technischen Objektes dienenden elektromagnetischen Wellen auch auf dem Boden B der Absorberhalle zu verhindert.

Im Beispiel der FIG 2 sind die separate, vertikale ein- und ausfahrbare Zentrumswelle W und die dazu gehörigen Hubmittel HM im einfacher Weise unmittelbar auf der Oberfläche des Bodens B der Absorberhalle montiert. Auch hier ist deren Hubbereich wiederum durch einen Doppelpfeil dargestellt. Falls bei einem Wechsel des der EMV-Prüfung zu unterwerfenen technischen Objektes die Tischplatte DR ausgetauscht werden soll, so wird die separate Zentrumswelle W wiederum aus den Kupplungsmitteln auf der Unterseite U ausgefahren. Die Tischplatte kann dann mit Hilfe der Rollmittel LK auf dem Zwischenboden UB aus dem Prüfraum ausgefahren und durch eine andere, mit einem anderen technischen Objekt versehene Tischplatte ausgetauscht werden. Selbstverständlich kann auch bei der Ausführung von FIG 2 ein Aufnahmeschacht AS vorgesehen sein, in den die separate Zentrumswelle W und die dazugehörigen Hubmittel HM zum Teil eingelassen sind. Bevorzugt sind in diesem Fall die Tiefe des Aufnahmeschachtes einerseits und die Längen der Hubmittel und der separaten Zentrumswelle W anderseits derart aufeinander abgestimmt, daß der durch den Doppelpfeil in FIG 2 symbolisierte Hubbereich vollständig im Inneren des Aufnahmeschachtes AS zu liegen kommt. Im diesem Fall kann der Schacht entsprechend der Ausführungsform von FIG 1 wiederum mit bevorzugt elektrisch leitenden Kontaktfedern gegenüber der Oberfläche des Bodens B abgedichtet werden.

## Patentansprüche

1. Drehtisch zum Abstellen von technischen Objekten, welche zur Prüfung von deren elektromagnetischer Verträglichkeit allseitig mit insbesondere hochfrequenten elektromagnetischen Wellen bestrahlt werden, mit
a) einer separaten Tischplatte (DR), welche auf der Unterseite (U) annähernd im Schwerpunkt, insbesondere in der Rotationsachse (Z), Kupplungsmittel (KO) aufweist,
b) einer separaten Zentrumswelle (W), welche über Hubmittel (HM,M2) vertikal in die Kupplungsmittel (KO) auf der Unterseite (U) eingefahren bzw. daraus ausgefahren werden kann,
c) Rollmitteln (LK), welche auf der Unterseite (U) der Tischplatte (DR) vorhanden bzw. anbringbar sind, so daß die separate Tischplatte (DR) im ausgefahrenen Zustand der Zentrumswelle (W) auf einem Boden (B,ZB) frei verschiebbar ist, und
d) einem Antrieb (M1;RA) zur Drehung der Tischplatte (DR), wenn die Zentrumswelle (W) in die Kupplungsmittel eingefahren ist.

2. Drehtisch nach Anpruch 1**, dadurch gekennzeichnet**, daß die separate Zentrumswelle (W) mit den Hubmitteln (HM,M2) in einem im Boden (B) eingelassenen Aufnahmeschacht (AS) untergebracht ist (FIG 1).

3. Drehtisch nach Anspruch 1 oder 2, **dadurch gekennzeichnet**, daß die Rollmittel (LK) desweiteren so ausgelegt sind, daß die Tischplatte (DR) auf einem Boden (B,ZB) im eingefahrenen Zustand der Zentrumswelle (W) kippfrei drehbar ist.

4. Drehtisch nach einem der vorangegangenen Ansprüch, **gekennzeichnet durch** Luftkissen (LK) als Rollmittel auf der Unterseite (U) der Tischplatte (DR).

5. Drehtisch nach einem der vorangegangenen Ansprüche, **dadurch gekennzeichnet**, daß
a) im Kopfbereich der Zentrumswelle (W), welcher den Kupplungsmittels (KO) auf der Unterseite (U) der Tischplatte (DR) zugewandt ist, Anschlußmittel (AM,K) insbesondere zur Energieversorgung und/oder zur Übergabe von Steuersignalen für das mindestens eine auf dem Drehtisch abgestellte technische Objekt angeordnet sind, und
b) auf der Oberseite (O) der Tischplatte (DR) annähernd in der Rotationsachse (Z) Mittel (D) vorhanden sind, welche einen Zugang zu den Anschlußmitteln (AM,K) zumindest in dem in die Kupplungsmittel (KO) eingefahrenen Zustand der Zentrumswelle (W) ermöglichen.

6. Drehtisch nach einem der vorangegangenen Ansprüche, **dadurch gekennzeichnet,**
a) die separate Tischplatte (DR) eine kreisrunde Form aufweist, und
b) der Antrieb (M1;RA) zur Drehung auf den Rand (R) der Tischplatte (DR) einwirkt (FIG 1).

7. Drehtisch nach einem der Ansprüche 1 bis 5, **dadurch gekennzeichnet**, daß
a) die Kupplungsmittel (KO) auf der Unterseite (U) der Tischplatte (DR) eine verdrehsichere Verbindung mit der Zentrumswelle (W) im eingefahrenen Zustand ermöglichen, und
b) der Antrieb (M1) zur Drehung der Tischplatte (DR) auf die Zentrumswelle (W) einwirkt, insbesondere in diese integriert ist (FIG 2).
